Europäisches Patentamt

European Patent Office

Office européen des brevets

(19)

(11) Publication number: **0 258 192**
**A2**

(12) # EUROPEAN PATENT APPLICATION

(21) Application number: **87830310.6**

(22) Date of filing: **25.08.87**

(51) Int. Cl.⁴: **G 01 R 13/30**

(30) Priority: **29.08.86 IT 2155986**

(43) Date of publication of application:
**02.03.88 Bulletin 88/09**

(84) Designated Contracting States:
**AT BE CH DE ES FR GB GR IT LI LU NL SE**

(71) Applicant: **GIBERTINI ELETTRONICA S.r.l.**
**Via Bellini 29/31**
**I-20026 Novate Milanese (Milano) (IT)**

(72) Inventor: **Gibertini Paolo**
**Via Ariosto, 3**
**I-20026 Novate Milanese Milan (IT)**

(74) Representative: **Perani, Aurelio et al**
**c/o JACOBACCI-CASETTA & PERANI S.p.A 7, Via**
**Visconti di Modrone**
**I-20122 Milano (IT)**

(54) **A microprocessor circuit device for continuously displaying a scale of the analog type.**

(57) This invention belongs to the technical field of industrial electronic control and measurement instruments (1) and relates to a microprocessor (4) circuit device for continuously displaying a scale of the analog type, of the type which comprises a transducer (2) for the quantity to be measured, an A/D converter (3), a microprocessor system (4), a monitor (6), and a video interface (5), which video interface (5) has a particular control logics (10) which allows rapid updating of a RAM storage (11) relating to the pixels on the monitor (6), in conformity with a suitable software allocated in an EPROM of the microprocessor (4), and through serialization of the data, sent to the monitor (6), formed by a shift register (13).

EP 0 258 192 A2

## Description

This invention relates to a microprocessor circuit device for continuously displaying a scale of the analog type, of the type which comprises a transducer for a quantity to be measured, circuit-wise connected to an analog-to-digital converter which converts an analog-type signal from the transducer into another, digital-type signal which is supplied to a microprocessor system which processes, through a video interface and its matching card, the input information to control the monitor tube whereon an optical scale of the quantity being measured is displayed.

As it is known, in the field of generic measurements, and specifically of metering, considerable skill is required to calibrate the desired measurement value.

More in detail, the normally still existing problematics is enhanced herein that with modern digital electronic instruments it is not always possible and easy to track by eye the upward and downward fluctuations of the values on display screens, such fluctuations being extremely fast and changeable.

Especially in the field of industrial metering, one cannot perceive oscillations about a value that can establish themselves while one is trying to optimize a measurement which is in percentage a component of an amount of values.

This is due essentially to the perceptive limitation of the human eye, and concurrently therewith, to the extremely high rate of change of existing display screens.

In order to solve that problematics, tapes provided with measuring notches have been used originally which have been utilized as measurement indicator means, either in a wound up condition or a stretched out condition.

In fact, in the roll instance, this was fully paid out and then taken back up elastically to perform a given range of measurements. Of course, the roll was located in a specially provided seat and had a fore reference index.

As an example, in the field of industrial weighing scales, this approach has been widely adopted.

However, it has a substantial limitation which not even the subsequent electromechanical embodiments succeeded to solve.

The roll has a length of its own, thereby it cannot represent an infinite number of measurements. Furthermore, when changing units of measurements, one has also to change the type of the roll or strip accordingly.

Therefore, even with the most up-to-date light beam approaches on a moving calibrated scale, one cannot fully cover the case study. It would be necessary to replace the roll each time either on account of scale limitations or change in the measurement units.

Lastly, such scales are never too detailed because minimal variations, which often change even rapidly or proceed in steps, cannot be appreciated by the notches.

For all these reasons, the prior art is yet to solve such operational limitations, which limitations are determined by a structure that has failed to marry the accuracy of the digital with the intuitive perception of the analog.

This invention has for its purpose the removal of the above-cited drawbacks, relating to the display devices currently in use, by making and providing a device for continuously displaying a scale of the analog type which affords direct perception of a measurement being carried out without any limitation to the range and/or change of measurement units, and ranking high in instrumental reliability.

These and other objects, such as will become apparent from the following description, are achieved, in accordance with this invention, by a microprocessor circuit device for continuously displaying a scale of the analog type, of the type which comprises a transducer for the quantity to be measured, circuit-wise connected to an analog-to-digital converter which converts the analog-type signal from the transducer into another digital type signal which is supplied to a microprocessor system which processes, through a video interface and its matching card, the input information to control the monitor tube whereon an optical scale of the quantity being measured is displayed, characterized in that said video interface has a control logic which effects through a controller a fast updating of a dynamic RAM storage, wherewith it interacts, on addresses and data being supplied from the cited microprocessor system, connected circuit-wise to said logics, thereby supplying then the data read in the RAM storage to a serializer, whence data will ultimately issue to effectively control the pixels on the monitor, thus bringing about continuous displaying of the cited optical scale.

The features and advantages of the invention will be more clearly apparent from a detailed description of a preferred, though not exclusive, embodiment of a microprocessor circuit device for continuously displaying an optical scale, as given hereinafter with reference to the accompanying drawings, furnished merely by way of illustration and, accordingly, not of limitation, and where:

    Figure 1 is a general block diagram of the device according to this invention in its general aspect,

    Figure 2 is a general block diagram of the device according to this invention in its characterizing configuration.

With reference to the drawing figures, and in particular to the first-mentioned one, indicated at 1 is a generic measuring instrument, such as an industrial weighing balance.

Indicated at 2 is, in connection with the cited example, a weight transducer which sends a signal to an analog-to-digital converter 3 having the function of matching, as by converting it, the analog-type signal, e.g. a voltage, from the transducer to a microprocessor system 4 which only accepts and reads out logic levels, that is, digital signals.

That microprocessor system 4, being equipped with a suitable software allocated in in EPROM storage, processes the input information, and through a particular video interface 5 controls and manages the spots (pixels) on the cathode ray tube of the monitor 6, provided with a video matching board 7.

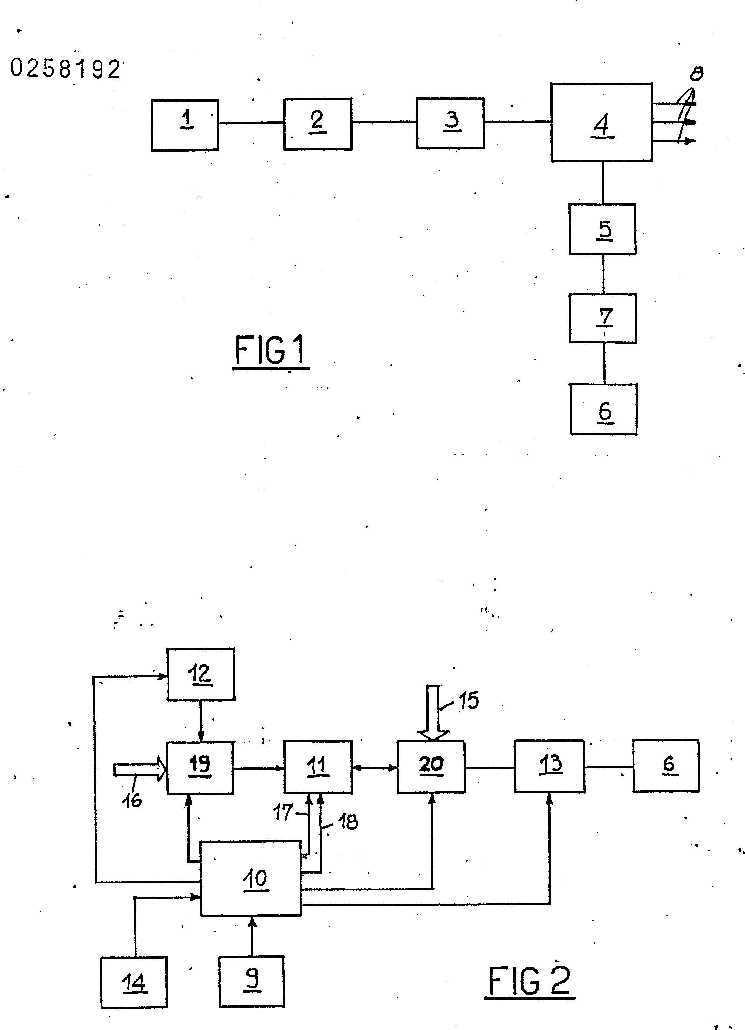

The microprocessor system 4 also has further outputs 8 for optional connection to keyboards, printers, plotters, automation systems, etc. With reference to the second-mentioned drawing figure, this shows a further block specification of the video interface 5 shown in Figure 1. In fact, all the control signals from the microprocessor system 4 would reach the video interface 5 with the intermediary of an I/O interface 9.

Such signals, e.g. reading or writing signals, are then supplied to a control logic 10, which is a circuit module operationally performing control of a dynamic RAM storage 11, of a CRT controller 12 which manages the cathode ray tube of the monitor 6, as well as of a serializer formed by a shift register 13, which are all connected circuit-wise to the control logic 10 itself.

A quartz 14, connected circuit-wise to the control logic 10, clocks the rate of the whole video interface 5. Data to be sent to the RAM storage 11 are supplied through a specific data bus 15, the related addresses being transmitted through a respective address bus 16.

Obviously the control logics 10 allows the storage cells of the RAM 11 to be read and written respectively through specific enables 17 and 18.

Finally, selection of the input-output data to the RAM 11, and their respective addresses, is accomplished respectively by means of a first multiplexer 19 and a second multiplexer 20.

After the foregoing, mainly structure-oriented description, operation of the device in question is the following.

Once the storage cells of the dynamic RAM 11 have been occupied for a specific video display on the monitor 6, the stored data are serialized toward the latter through the shift register 13, which sends them out sequentially one after another. From the operational standpoint, this results in the picture of an optical scale being formed on the monitor 6, which has a flag cursor in the proximities of the numbered measuring notches.

The pixels, which represent the spots on the cathode ray tube of the monitor 6, are each described by a plurality of bits identifying each position. This means that each bit configuration stored in the RAM 11 will identify, as mentioned, one pixel configuration on the monitor, i.e. the so-called video display. Because the RAMs are dynamic ones, for each update of them there corresponds a particular configuration, which may convert optically on the monitor 6 in either persistence of the same image or its development into another image.

The change or otherwise is decided by the microprocessor system 4 according to the change or else signals supplied to it by the transducer 2 and on completion of the processing carried out by the software allocated thereto. In any case, it is the control logic 10 which effects, subsequently to said processing, the updating of the storage cells in the RAM 11, and hence, correspondingly of the pixels on the monitor 6 by means of the CRT controller 12.

The RAM storage 11 updating rate is of 2 bytes per microsecond. Thus, the displaying on the monitor 6 will appear continuous and without unpleasant jerks for the observer.

Each character displayed is, by managing the pixels on the monitor 6, encoded at 16 bits.

Of course, through the control logic 10, the microprocessor system 4 can go to read and write anything in the RAMs 11, by using the signals 17 and 18 respectively.

In summary, the microprocessor system 4 will send depending on the signals from the transducer 2 and basing upon its own software which equips it, commands and information to the control logic 10, which updates at a high rate the dynamic RAMs 11 and provides, through the CRT controller 12 and the shift register 13, a corresponding video display on the monitor 6 representing an optical scale, and this for each data and address configuration presently in the storage cells of those same RAMs.

Thus, the invention achieves the objects set forth.

In fact, through that video interface 5 and thanks to the particular software stored in the microprocessor system 4, it now becomes possible to display on any monitor 6 an analog scale relating to any quantity and for any measurement in a continuous and pleasant manner for the observer.

This means that there are no longer limitations to the range of measurement or to changing its related unit of measurement, because both the range fields and all the measurement units have already been previously arranged in the applicative software of the microprocessor system 4 which can be updated each time for further particular objectives.

With such a device, the industrial metering operation is made easier, because there is a finer and more direct measurement perception.

Of course, many circuit and program modifications and changes may be applied to the device of this invention without departing from the scope of its inventive concept.

## Claims

1. A microprocessor circuit device for continuously displaying a scale of the analog type, of the type which comprises a transducer (2) for the quantity to be measured, circuit-wise connected to an analog-to-digital converter (3) which converts an analog-type signal from the transducer into another digital type signal which is supplied to a microprocessor (4) system which processes, through a video interface (5) and its matching card (7), the input information to control the monitor tube (6) whereon an optical scale of the quantity being measured is displayed, characterized in that said video interface (5) has a control logic (10) which effects through a controller a fast updating of a dynamic RAM storage (11), wherewith it interacts, on addresses and data being supplied from the cited microprocessor system (4), connected circuit-wise to said logic (10), thereby supplying then the data read in the RAM storage (11) to a serializer (13), whence data will ultimately issue to effectively control the pixels on the monitor (6), thus bringing about continuous displaying of the cited optical scale.

2. A microprocessor circuit device according to Claim 1, characterized in that the information is processed by the microprocessor (4) in accordance with a software program which manages the pixels on the monitor (6), allocated in an EPROM storage.

3. A microprocessor circuit device according to Claim 1, characterized in that the updating is carried out at a rate of at least 2 bytes per microsecond.

4. A microprocessor circuit device according to Claim 1, characterized in that for the updating each character is encoded at 16 bit.

5. A microprocessor circuit device according to Claim 1, characterized in that said serializer is formed by a shift register (13).

6. A microprocessor circuit device for continuously displaying a scale of the analog type, according to the preceding claims and. as herein described and illustrated for the objects specified.

0258192

FIG 1

FIG 2